Europäisches Patentamt

European Patent Office

Office européen des brevets

(19)

(11) Veröffentlichungsnummer: **0 092 086**
**B1**

# (12) EUROPÄISCHE PATENTSCHRIFT

(45) Veröffentlichungstag der Patentschrift:
**13.11.85**

(21) Anmeldenummer: **83103250.3**

(22) Anmeldetag: **31.03.83**

(51) Int. Cl.⁴: **H 01 R 23/72,** H 05 K 7/10

(54) Anschlussvorrichtung für ein plattenförmiges elektrisches Gerät.

(30) Priorität: **15.04.82 DE 3213884**

(43) Veröffentlichungstag der Anmeldung:
**26.10.83 Patentblatt 83/43**

(45) Bekanntmachung des Hinweises auf die Patenterteilung:
**13.11.85 Patentblatt 85/46**

(84) Benannte Vertragsstaaten:
**CH FR GB IT LI**

(56) Entgegenhaltungen:
**EP - A - 0 030 763**
**DE - A - 2 435 399**
**DE - A - 2 847 163**
**US - A - 3 924 918**

(73) Patentinhaber: **Siemens Aktiengesellschaft, Berlin und München Wittelsbacherplatz 2, D-8000 München 2 (DE)**

(72) Erfinder: **Schaller, Werner, Dipl.-Ing., Hans-Thoma-Strasse 11, D-6840 Lampertheim (DE)**

## Beschreibung

Die Erfindung bezieht sich auf eine Anschlußvorrichtung für ein im Randbereich mit Anschlüssen versehenes, plattenförmiges elektrisches Gerät, vorzugsweise eine elektronische Schaltung, mit Leiterzügen einer Leiterplatine.

Bei bekannten Anschlußvorrichtungen der obengenannten Art, beispielsweise IC-Chips in Dual-in-line-Gehäusen, werden die im Randbereich vorgesehenen Anschlüsse des IC abgewinkelt und entweder in einer Steckerfassung, die auf der Schaltungsplatine mit den Leiterzügen verbunden ist, eingesteckt oder direkt mit den Leiterzügen der Leiterplatine verbunden, in dem Löcher in die Leiterzüge eingebohrt werden und die abgewinkelten Anschlüsse in diesen Leiterzügen eingelötet werden. Dies ist zwar eine relativ sichere Verbindungsmethode, jedoch sehr aufwendig, da die Leiterzüge mit entsprechenden Löchern versehen werden müssen und die Anschlüsse in diese Löcher einzufädeln sind, bevor einen Verlötung stattfinden kann. Hinzu kommt, daß die sogenannten Dual-in-line Gehäuse bereits Filmabschnitte aufnehmen, in denen IC-Chips gehalten und kontaktiert sind, wobei die elektrischen Anschlußstellen auf dem Filmabschnitt nach außen geführt sind und zusätzlich mit den Anschlüssen, die im Gehäuse gehalten sind, zu verbinden sind. Zusätzlich zur aufwendigen Befestigung benötigt diese Vorrichtung einen relativ großen Platz auf der Leiterplatte. Man hat daher bereits bei elektronischen Schaltungen die Filmabschnitte mit den IC-Chips durch Löten mit den Leiterzügen der Leiterplatte verbunden. Hierzu werden die Filmabschnitte von Hand in die erforderliche, die Anschlüsse deckende Position gebracht und festgehalten, während mittels eines Lötkolbens die sich nun gegenüberliegenden und mit Lötzinn versenen Randkontakte des Filmabschnittes mit den ebenfalls mit Lötzinn versehenen Gegenkontakten auf den Leiterbahnen verlötet werden. Bei dieser manuellen Arbeit muß sehr genau auf die richtige Positionierung geachtet werden. Außerdem stellt die wegen der Kleinheit der Filmabschnitte schwierige Lötung erhöhte Anforderungen an die die Lötung durchführende Person. Der gesamte Vorgang erfordert wegen der notwendigen Präzion erheblichen Zeitaufwand. Da der beschriebene manuelle Vorgang von der jeweiligen Qualifikation und Verfassung der die Positionierung und Lötung durchführenden Person abhängt, ist mit einer nicht korrekten Lötung oder gar mit der Zerstörung eines Teiles der in einer Fertigungsserie nacheiannder einzulötenden Filmabschnitte mit den IC-Chips zu rechnen, so daß oft ein unverhältnismäßig hoher Fertigungsausschuß entsteht.

Es ist weiterhin möglich, für die Positionierung der Filmabschnitte mit den IC-Chips Fenstermasken zu verwenden, wobei die Fenster so dimensioniert und angebracht sind, daß die Filmabschnitte, wenn sie in die Fenster von Hand eingelegt sind, die vorgeschriebene Position einnehmen. Der Nachteil des Festhaltens und der Handlötung und der damit verbundene Zeitaufwand und das Ausschußrisiko bleiben jedoch immer noch bestehen.

Außerdem erschwert die Maske das Festhalten und das Anlöten des Filmabschnittes.

Der Erfindung liegt somit die Aufgabe zugrunde, eine Anschlußvorrichtung der obengenannten Art zu schaffen, die insbesondere für relativ kleine elektronische Schaltungsplatinen verwendbar ist und durch die sich die Verbindung von Anschlüssen und Leiterzügen schneller, einfacher und sicherer herstellen läßt. Dies wird auf einfache Weise dadurch erreicht, daß die Leiterplatine mit einem der Größe der Platte des plattenförmigen Gerätes im wesentlichen angepaßten Fenster versehen ist, dessen Fensterränder in das Fenster hineinragende, elastisch nachgiebige Haltezungen unterschiedlicher Länge aufweisen, die zumindest teilweise Leiterzugsenden bilden, die mit den Anschlüssen im Randbereich des Gerätes korrespondieren. Hierbei ist es lediglich erforderlich, das Gerät unter Wegbiegen der Haltezungen mit der Unterseite des Gerätes soweit durch das Fenster hindurchzudrücken, bis der Rand über die Enden der kürzeren Haltezungen hinausgelangt, so daß diese nicht mehr weggebogen werden und zurückfedern. Nach Loslassen des Gerätes ist dieses zwischen den langen und kurzen Haltezungen eingespannt. Sofern die Anschlußvorrichtung höheren Beanspruchungen ausgesetzt wird, kann es vorteilhaft sein, hernach eine Verlötung zwischen Anschlüssen und Leiterzügen vorzunehmen. Um eine gleichmäßige Verklemmung der Kanten des Gerätes zu erreichen, ist es vorteilhaft, wenn die unterschiedlich langen Haltezungen paarweise angeordnet sind. Um zu verhindern, daß das Gerät in einer unerwünschten Lage mit der Leiterplatine in Verbindung gebracht wird, ist es vorteilhaft, wenn Vorsprünge und/oder Ausnehmungen an der Leiterplatine bzw. dem Randbereich des Gerätes zur Verdrehungssicherung wechselseitig ineinandergreifen. Hier hat es sich als vorteilhaft erwiesen, wenn Einführhilfen für das Gerät an der Leiterplatine vorgesehen sind. Dies kann durch zwei diagonal gegenüberliegende Ecken erfolgen. Hierdurch wird eine noch genauere Positionierung der Haltezungen auf den Leiterzügen gewährleistet, was insbesondere von Vorteil ist, wenn die Anzahl oder die Größe der Haltezungen unterschiedlich bzw. ihre geometrische Anordnung unsymmetrisch ist. Eine einfache Herstellung für die Haltezungen ergibt sich, wenn die Haltezungen Teil der Kaschierungen der Leiterplatinen sind. Werden die Leiterplatinen doppelseitig kaschiert, so kann das plattenförmige Gerät mit den Anschlüssen, sofern es die Stärke der Leiterplatine besitzt, mit der Innenseite der Kaschierung elektrisch leitend verbunden werden. Werden dünnere Leiterplatinen verwendet, so ist es zur Erzielung eines größeren Anpreßdruckes vorteilhaft, wenn die Haltezun

gen der Unterseite auf der Oberseite des Geräterandes und die Haltezungen der Oberseite auf der Unterseite des Geräterandes liegen. Da die Kaschierungen im allgemeinen relativ dünn sind, ist es vorteilhaft, wenn die Leiterplatine einen flexible Leiterplatine ist, und das isolierende Trägermaterial der Leiterplatine Bestandteil der Haltezungen ist. Die erfindungsgemäße Anschlußvorrichtung ist insbesondere für kleinere elektrische bzw. elektronische Geräte geeignet. Sie hat sich als besonders vorteilhaft erwiesen, wenn das elektrische Gerät ein mit IC-Chips bestückter Filmabschnitt (Mikropack) ist.

Anhand der Zeichnung wird ein Ausführungsbeispiel gemäß der Erfindung beschrieben und die Wirkungsweise näher erläutert.

Es zeigt

Fig. 1 eine Explosionsdarstellung bei vor dem Fenster in der Leiterplatine liegenden elektrischen Gerät,

Fig. 2 einen in die Leiterplatine bei Doppelkaschierung eingeschnappten Mikropack in Seitenansicht im Schnitt,

Fig. 3 die gleiche Ansicht bei überkreuzten Haltezungen der Leiterplatine und

Fig. 4 die Ansicht eines eingesetzten Mikropacks bei einseitiger Kaschierung der Leiterplatine.

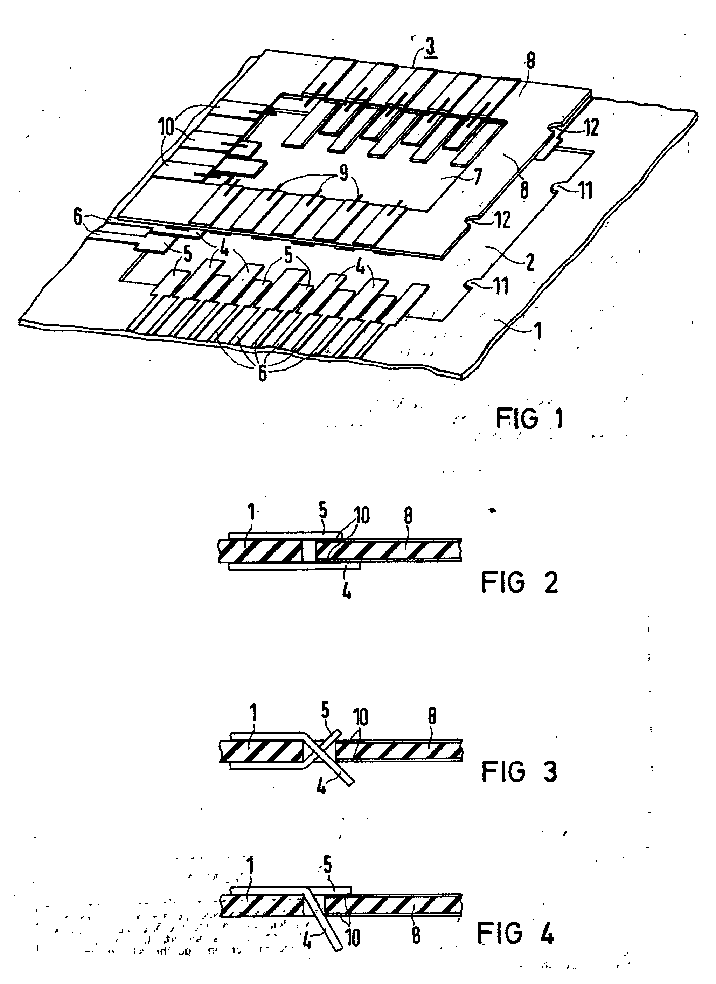

Die in der Zeichnung dargestellte Anschlußvorrichtung besteht aus der Leiterplatine 1, die mit einem Fenster 2 versehen ist, das dem elektrischen Gerät 3, im vorliegenden Fall einem plattenförmigen Mikropack, in der Größe angepaßt ist. Die Leiterplatine 1 ist mit in das Fenster 2 hineinragenden Haltezungen 4 und 5 ausgestattet, die zumindest teilweise in Leiterzügen 6 enden und die elastisch nachgiebig sind. Die Leiterzüge 6 können aus der auf die Leiterplatine 1 aufgebrachten Kaschierung, die durch Ätzen in die aus der Figur ersichtliche Form gebracht wird, bestehen. Sie können aber auch, sofern die Leiterplatine eine flexible Leiterplatte ist, als Grundmaterial das Trägermaterial der Leiterplatine aufweisen und nur mit einer dünnen Kaschierung versehen sein. Das elektrische Gerät 3 besteht aus dem eigentlichen IC-Chip 7, der mit dem Filmabschnitt 8 über spinnenförmige Verbindungen 9 elektrisch leitend in Verbindung gebracht ist. Die auf den Filmabschnitt 8 aufgebrachten Anschlüsse tragen das Bezugszeichen 10. Sie können auf beiden Seiten des Filmabschnittes 8 angebracht werden, wie dies die Fig. 1 zeigt, so daß sowohl die Haltezungen 4 als auch die Haltezungen 5 zur Kontaktierung herangezogen werden können. Vorsprünge 11 am Rand des Fensters 2 korrespondieren mit Ausnehmungen 12, so daß eine verdrehsichere Einführung des Filmabschnittes 8 in das Fenster 2 gewährleistet ist. Wird nun der Filmabschnitt 8 in das Fenster 2 eingeführt, so verbiegen sich sowohl die Haltezungen 4 als auch die Haltezungen 5, so daß der Filmabschnitt 8 durch das Fenster um einen gewissen Betrag hindurchgeschoben werden kann, und zwar solange, bis die Haltezungen 5 am Rand des Filmabschnittes 8 vorbeischnellen, so daß die Haltezungen 5 oberhalb und die Haltezungen 4 unterhalb des Filmabschnittes 8 zu liegen kommen. Nach Freigabe stellt sich der Filmabschnitt 8 in einer Mittellage ein. Die Möglichkeiten der Kontaktierungen sind aus den Fig. 2 bis 4 zu ersehen. Im Ausführungsbeispiel nach Fig. 2 ist eine Doppelkaschierung der Leiterplatine 1 vorgesehen, so daß die Haltezungen 5 oberhalb und die Haltezungen 4 unterhalb der Leiterplatine 1 liegen. Der Filmabschnitt 8 mit den Anschlüssen 10 liegt im eingeschnappten Zustand zwischen den Haltezungen 4 und 5 in gleicher Höhe wie die Leiterplatine 1. Sie ist auch in gleicher Stärke ausgeführt. Haben Leiterplatine 1 und Filmabschnitt 8 unterschiedliche Stärken, so hat sich die aus Fig. 3 ersichtliche Lösung als vorteilhaft erwiesen. Hier werden die Anschlüsse 10 zangenförmig von den Haltezungen 4 und 5 umgriffen. Die Haltezunge 5 liegt hier auf der oberen Seite des Filmabschnittes 8 und die Haltezunge 4 auf der unteren, wobei die Haltezunge 4 zur oberen Kaschierung und die Haltezunge 5 zur unteren Kaschierung gehören. Bei einseitiger Kaschierung ergibt sich die aus Fig. 4 ersichtliche Version. Hier kann es vorteilhaft sein, lediglich die Haltezungen 5 zur Kontaktierung heranzuziehen. Dies wird entsprechend der Anzahl der zu kontaktierenden Anschlüsse vorzusehen sein. Im allgemeinen haben die Mikropacks lediglich auf einer Seite Anschlüsse 10, so daß mit einer Kaschierung ausgekommen werden kann und bei Verwendung einer flexiblen Leiterplatine die Halterungszungen aus dem Grundmaterial der Leiterplatine bestehen können.

**Patentansprüche**

1. Anschlußvorrichtung für ein im Randbereich mit Anschlüssen versehenes, plattenförmiges elektrisches Gerät (3), vorzugsweise eine elektronische Schaltung mit Leiterzügen einer Leiterplatine (1), dadurch gekennzeichnet, daß die Leiterplatine (1) mit einem der Größe der Platte des plattenförmigen Gerätes (3) im wesentlichen angepaßten Fenster (2) versehen ist, dessen Fensterränder in das Fenster hineinragende, elastisch nachgiebige Haltezungen (4, 5) unterschiedlicher Länge aufweisen, die zumindest teilweise Leiterzugsenden (6) bilden, die mit den Anschlüssen (10) im Randbereich des Gerätes (3) korrespondieren.

2. Vorrichtung nach Anspruch 1, dadurch gekennzeichnet, daß die unterschiedlich langen Haltezungen (4, 5) paarweise angeordnet sind.

3. Vorrichtung nach Anspruch 1 oder 2, dadurch gekennzeichnet, daß Vorsprünge (11) und/oder Ausnehmungen (12) an der Leiterplatine (1) bzw. dem Randbereich des Gerätes (3) zur Verdrehungssicherung wechselseitig ineinandergreifen.

4. Vorrichtung nach Anspruch 1, 2 oder 3, dadurch gekennzeichnet, daß Einführhilfen (13) für das Gerät (3) an der Leiterplatine (1) vorgesehen sind.

5. Vorrichtung nach einem der vorhergehenden Ansprüche, dadurch gekennzeichnet, daß die Haltezungen (4, 5) Teil der Kaschierungen der Leiterplatinen (1) sind.

6. Vorrichtung nach Anspruch 5, dadurch gekennzeichnet, daß die Leiterplatinen (1) doppelseitig kaschiert sind.

7. Vorrichtung nach einem der vorhergehenden Ansprüche, dadurch gekennzeichnet, daß die Leiterplatine (1) eine flexible Leiterplatine ist.

8. Vorrichtung nach Anspruch 7, dadurch gekennzeichnet, daß das isolierende Trägermaterial der Leiterplatine (1) Bestandteil der Haltezungen ist.

9. Vorrichtung nach einem der vorhergehenden Ansprüche, dadurch gekennzeichnet, daß die Haltezungen (4, 5) der Unterseite auf der Oberseite des Geräterandes und die Haltezungen (4) der Oberseite auf der Unterseite des Geräterandes liegen.

10. Vorrichtung nach einem der vorhergehenden Ansprüche, dadurch gekennzeichnet, daß die Haltezungen (4, 5) und die Anschlüsse (10) miteinander verlötet sind.

11. Vorrichtung nach einem der vorhergehenden Ansprüche, dadurch gekennzeichnet, daß das elektrische Gerät (3) ein mit IC-Chips bestückter Filmabschnitt (Mikropack) ist.

## Claims

1. A connection assembly for a plate-shaped electrical device (3) which is provided with terminals in the boundary region, particularly for an electronic circuit having conducting sections of a conductor board (1), characterised in that the conductor board (1) is provided with a window (2) which corresponds essentially to the size of the plate of the plate-shaped device (3) and the edges of which window project into the window, and have elastically resilient holding tongues (4, 5) of different lengths which at least partially form conductor section ends (6) corresponding to the terminals (10) in the boundary region of the device (3).

2. An assembly as claimed in Claim 1, characterised in that the holding tongues (4, 5) of different length are arranged in pairs.

3. An assembly as claimed in Claim 1 or Claim 2, characterised in that projections (11) and/or recesses (12) on the conductor board (1) and in the boundary region of the device (3) mutually interengage for torsional resistance.

4. An assembly as claimed in Claim 1, 2 or 3, characterised in that insertion aids (13) for the device (3) are arranged on the conductor board (1).

5. An assembly as claimed in one of the preceding Claims, characterised in that the holding tongues (4, 5) are part of the coating of the conductor boards (1).

6. An assembly as claimed in Claim 5, characterised in that the conductor boards (1) are coated on both sides.

7. An assembly as claimed in one of the preceding Claims, characterised in that the conductor board (1) is a flexible conductor board.

8. An assembly as claimed in Claim 7, characterised in that the insulating carrier material of the conductor board (1) forms part of the holding tongues.

9. An assembly as claimed in one of the preceding Claims, characterised in that the holding tongues (4, 5) of the underside are arranged on the upper side of the edge of the device and the holding tongues (4) of the upper side are arranged on the underside of the edge of the device.

10. An assembly as claimed in one of the preceding Claims, characterised in that the holding tongues (4, 5) and the terminals (10) are soldered to one another.

11. An assembly as claimed in one of the preceding Claims, characterised in that the electrical device (3) is a film section (micropack) which is provided with IC-chips.

## Revendications

1. Dispositif de connexion pour un appareil électrique (3) en forme de plaque, pourvu de connexions dans la région du bord, de préférence pour un circuit électronique, avec des pistes conductrices d'une platine à circuit imprimé (1), caractérisé en ce que la platine (1) est pourvue d'une fenêtre (2) essentiellement adaptée à la grandeur de la plaque de l'appareil (3) en forme de plaque et dont les bords présentent des languettes de maintien (4, 5) élastiquement flexibles, faisant saillie dans la fenêtre et ayant des longueurs différentes, qui forment en partie au moins des extrémités de pistes conductrices (6) correspondant aux connexions (10) dans la région du bord de l'appareil (3).

2. Dispositif selon la revendication 1, caractérisé en ce que les languettes (4, 5) de longueurs différentes sont disposées par paires.

3. Dispositif selon la revendication 1 ou 2, caractérisé en ce que des protubérances (11) et/ou des encoches (12) sur la platine (1) respectivement sur la région du bord de l'appareil (3) s'interpénètrent en vue de la fixation en rotation.

4. Dispositif selon la revendication 1, 2 ou 3, caractérisé en ce que des moyens (13) sont prévus sur la platine (1) pour faciliter la mise en place de l'appareil (3).

5. Dispositif selon une des revendications précédentes, caractérisé en ce que les languettes (4, 5) font partie des couches d'où sont formées les pistes conductrices des platines (1).

6. Dispositif selon la revendication 5, caractérisé en ce que les platines (1) sont à double face.

7. Dispositif selon une des revendications précédentes, caractérisé en ce que la platine (1) est flexible.

8. Dispositif selon la revendication 7, caractérisé en ce que le matériau support isolant de la platine (1) est un constituant des languettes.

9. Dispositif selon une des revendications précédentes, caractérisé en ce que les languettes (5) de la face inférieure de la platine s'appliquent contre le dessus du bord de l'appareil et les languettes (4) de la face supérieure s'appliquent contre le dessous du bord de l'appareil.

10. Dispositif selon une des revendications précédentes, caractérisé en ce que les languettes (4, 5) et les connexions (10) sont soudées ensemble.

11. Dispositif selon une des revendications précédentes, caractérisé en ce que l'appareil électrique (3) est un morceau de film équipé de puces à circuit intégré (micropack).

FIG 1

FIG 2

FIG 3

FIG 4